# EUROPEAN PATENT APPLICATION

(11) **EP 4 203 004 A2**
(43) Date of publication of application: **28.06.2023**
(21) Application number: 22207569.9
(22) Date of filing: 15.11.2022
(51) Int. Cl.: H01L 23/00

(54) **STRESS ARREST LIP ON COPPER PAD FOR LOW ROUGHNESS COPPER**

(30) Priority: 24.12.2021 US 202117561824
(71) Applicant: Intel Corporation, Santa Clara, CA 95054 (US)
(72) Inventor: KONG, Jieying, Chandler, AZ 85248 (US); ANGOUA, Bainye, Chandler, AZ 85226 (US); SENEVIRATNE, Dilan, Phoenix, AZ 85048 (US); BRYKS, Whitney, Tempe, AZ 85284 (US); ECTON, Jeremy, Gilbert, AZ 85298 (US)
(74) Representative: HGF

(57) **Abstract**

A system includes a metallic contact integrated onto a semiconductor integrated circuit substrate. The metallic contact has a contact surface to make electrical contact with a trace through a dielectric layer over the semiconductor circuit substrate and the metallic contact. The semiconductor circuit can include a trace that connects the contact to a package pad to enable external access to the signal from off the semiconductor circuit. The metallic contact includes a vertical lip extending vertically into the dielectric layer above the contact surface.

## Description

### FIELD

Descriptions are generally related to computer systems, and more particular descriptions are related to semiconductor layers of integrated circuits.

### BACKGROUND

Integrated circuit substrates have metal contacts for electrical routing, which are commonly made of copper. Integrated circuit substrates are typically coated with a layer of bulk dielectric to provide electrical isolation of the circuit. The bulk dielectric is designed to have particular dielectric properties to provide the electrical isolation, and particular mechanical properties such as modulus to ensure a solid cover layer. The integrated circuits can be subject to mechanical stress and thermal variation, which can cause thermal expansion and contraction as well as mechanical stresses.

The metal to dielectric interface is traditionally a weak point due to stress buildup between the dissimilar materials of the metal and dielectric. One common failure includes delamination along the side of the contact, with in-plane side fracturing and side wall delamination. Sidewall cracking tends to extend into the dielectric material. Cracks worsen during stress.

The sidewall delamination does not tend to occur when the contact is made of high roughness copper, given the improved mechanical coupling between the contact and the dielectric. However, high roughness copper has a very high surface area, which significantly increases insertion loss. Thus, there is traditionally a tradeoff between high roughness for good adhesion and mechanical stability of the circuit, but at the cost of high insertion loss. The insertion loss is an increasing significant factor with high-speed, high-bandwidth communication.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1** is a block diagram of an example of an integrated circuit substrate with a metallic contact connected with a package pad.
**Figures 2A-2G** represent stages in the creation of an integrated circuit with a vertical lip on a metallic contact.
**Figures 3A-3G** represent stages in the creation of an integrated circuit with a metallic contact having a vertical lip with a tapered edge.
**Figures 4A-4F** represent stages in the creation of an integrated circuit with a metallic contact having a vertical lip with a scalloped edge.
**Figures 5A-5G** represent stages in the creation of an integrated circuit with a metallic contact having a vertical lip with a ribbed edge.
**Figure 6** represents an example of an integrated circuit with a metallic contact having multiple vertical lips.
**Figure 7** is a flow diagram of an example of a process for creating an integrated circuit with a vertical lip on a metallic contact.
**Figure 8** is a block diagram of an example of a computing system in which an integrated circuit with a vertical lip on a metallic contact can be implemented.
**Figure 9** is a block diagram of an example of a mobile device in which an integrated circuit with a vertical lip on a metallic contact can be implemented.
**Figure 10** is a block diagram of an example of a multi-node network in which an integrated circuit with a vertical lip on a metallic contact can be implemented.

Descriptions of certain details and implementations follow, including non-limiting descriptions of the figures, which may depict some or all examples, and well as other potential implementations.

### DETAILED DESCRIPTION

As described herein, a system includes a metallic contact with a stress-arresting lip. The metallic contact is integrated onto a semiconductor integrated circuit substrate. The metallic contact has a contact surface to make electrical contact with a trace through a dielectric layer over the semiconductor circuit substrate and the metallic contact. The metallic contact includes a vertical lip extending vertically into the dielectric layer above the contact surface. The vertical lip can improve mechanical coupling of the metal contact and the dielectric, reducing the mechanical stress on the circuit.

With the stress-arrest lip on the contacts, high-speed communication contacts can be made with low roughness metal, improving insertion loss properties, while reducing the factors that cause delamination. The semiconductor circuit can include a trace that connects the contact to a package pad to enable external access to the signal from off the semiconductor circuit. The vertical lip can be shaped in various ways to improve the mechanical coupling of the dielectric to the contact, thus enabling low insertion loss while maintaining good substrate reliability for integrated circuit (IC) packaging.

The vertical lip can prevent in-plane delamination extending to the side wall. In-plane delamination is acceptable as long as it is within certain range, for example, less than 10 um (microns) after chemical etching processes (e.g., desmear and etching). In-plane delamination can be partially filled by a metal plating process following the chemical etching processes, which has not been shown to contribute to delamination cracking in end of line product or product after stress evaluation.

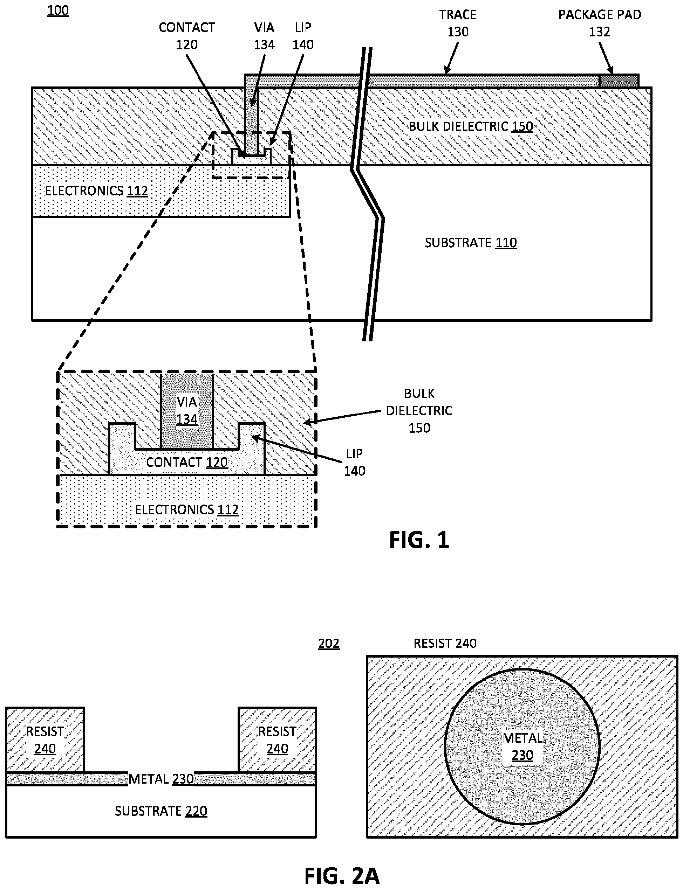

**Figure 1** is a block diagram of an example of an integrated circuit substrate with a metallic contact connected with a package pad. Circuit 100 represents an integrated circuit with a metallic contact having a stress arrest lip. The components of circuit 100 are not necessarily to scale and circuit 100 does not necessarily show all components.

Circuit 100 represents an electronic assembly that includes substrate 110, which represents a semiconductor substrate that forms the basis of an integrated circuit die. Electronics 112 represent integrated circuit components integrated into substrate 110. Electronics 112 include one or more components that provide signals or receive signals, or both provide signals and receive signals, or part of circuit which provide or receive signals, from an external source. For example, the connection can be for HSIO (high speed input/output).

Contact 120 represents a connection point for the signal exchange with package pad 132 through trace 130. Package pad 132 represents a pad or contact for connection of the die of substrate 110 to a package, whether for flip chip bonding or wire bonding. Trace 130 represents a metal (such as copper) to transmit the signal between package pad 132 and contact 120, to electronics 112. Trace 130 is electrically connected to contact 120.

As illustrated in the cross section of circuit 100, trace 130 connects to package pad 132 over bulk dielectric 150, and connects to contact 120 through via 134. Via 134 can represent a vertical channel through bulk dielectric 150 to make electrical contact between trace 130 and contact 120. Via 134 passes vertically through bulk dielectric 150 to make electrical contact with a surface of contact 120. Typically, via 134 will have a pad such as pad 132 connecting via 134 to trace 130. As illustrated in circuit 100, contact 120 includes a vertical portion or portions that form a stress arresting lip. Lip 140 represents the vertical lip structure. Contact 120 and trace 130 can be made from low roughness copper or other low roughness metal.

Lip 140 extends vertically into the dielectric layer of bulk dielectric above the surface of contact 120 that will connect to via 134. Lip 140 can be considered physically and electrically part of contact 120, and is separately labeled to illustrate the structure. The vertical lip structure is more evident in the close-up view designated by the dashed lines.

Lip 140 is illustrated as a simple vertical structure. Such a simple structure can be formed by deposition of more metal material on contact 120, patterned with lithographic processing. Lip 140 can be a more complex structure, formed based on etching processing to create more complex structures that improve the mechanical coupling of contact 120 to bulk dielectric 150. Whether a simple structure or a more complex structure, lip 140 can reduce or prevent delamination failure in circuit 100 with respect to contact 120. Preventing delamination around contact 120 can prevent cracking in vertical directions.

**Figures 2A-2G** represent stages in the creation of an integrated circuit with a vertical lip on a metallic contact. **Figure 2A** illustrates circuit state 202, with metal layer 230 formed on substrate 220. The view on the left represents a cross-section view of the circuit state. The view on the right represents a top view of the circuit state. Circuit state 202 can represent a semi-additive process (SAP) process flow after an electroless (e-less) deposition layer of metal 230.

In one example, substrate 220 represents an electronic circuit. In one example, substrate 220 represents a layer of electrical isolation, such as a nitride or oxide layer or an organic buildup material such as ABF, on which a contact will be formed to connect with traces or circuits under the contact through a pillar or via. Metal 230 represents material for a metal contact on substrate 220, such as a copper pad.

In circuit state 202, the processing applies a layer of photoresist material represented as resist 240 in circuit state 202. There is an opening patterned into resist 240, which the top view represents as a circular opening in the resist to expose metal 230.

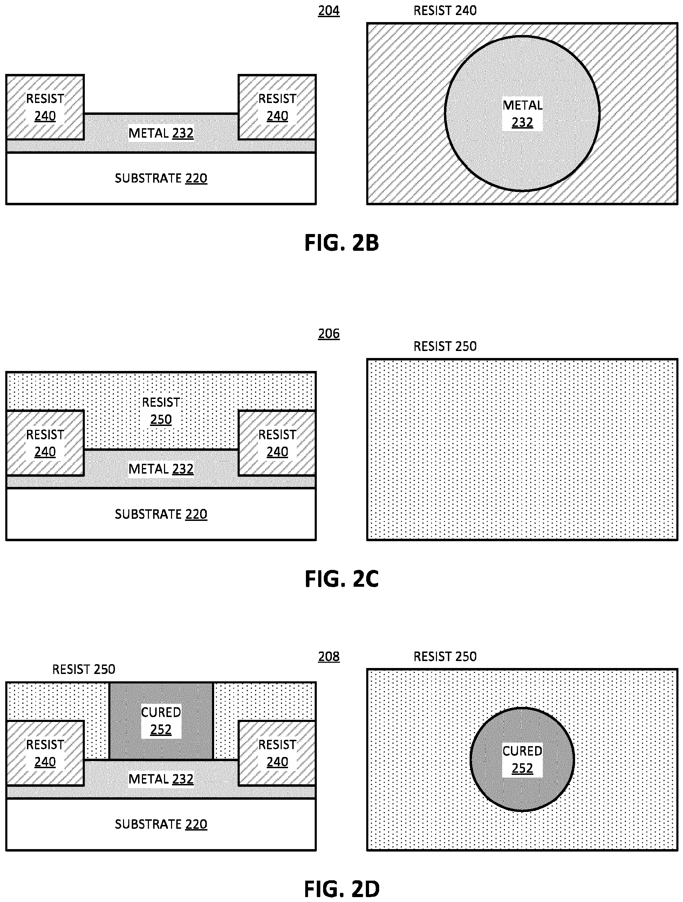

**Figure 2B** illustrates a cross-section view and a top view for circuit state 204. In circuit state 204, the metal layer is plated or formed in the patterned area of resist 240. Metal 232 represents the patterned metal layer plated to the desired thickness.

**Figure 2C** illustrates a cross-section view and a top view for circuit state 206. In circuit state 206, the processing can coat the metal layer and first resist layer, resist 240, with resist 250.

**Figure 2D** illustrates a cross-section view and a top view for circuit state 208. In circuit state 208, the processing exposes and develops resist 250 to create patterning represented by cured region 252, which represents the cured region of resist 250. Cured region 252 can pattern over metal 232 but not cover the entire metal region exposed by resist 240, which is the reason for the second resist layer.

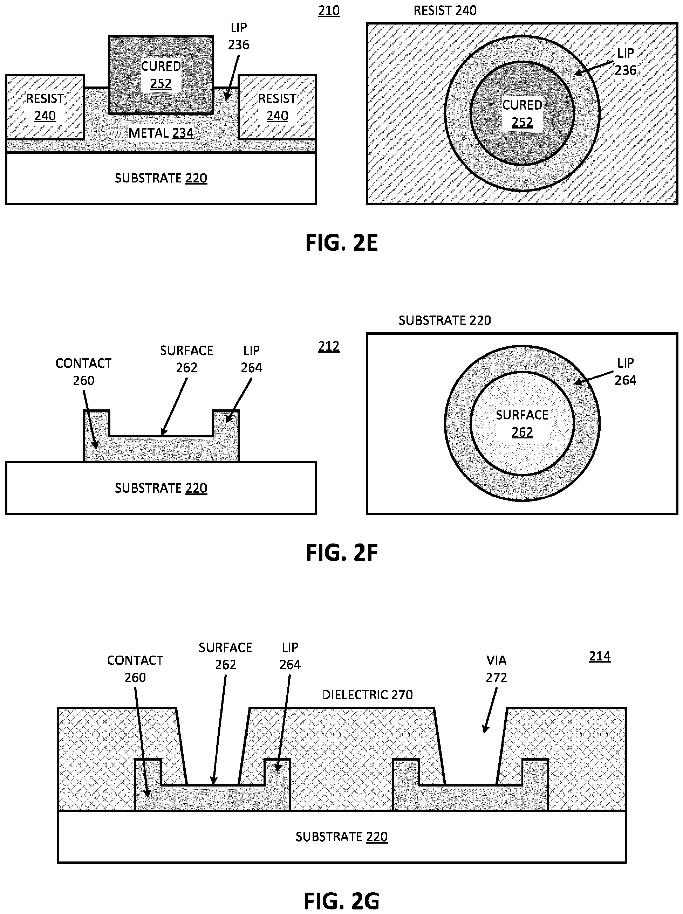

**Figure 2E** illustrates a cross-section view and a top view for circuit state 210. In circuit state 210, the processing can remove the unpatterned or undeveloped region of resist 250 to expose a portion of the metal layer between cured region 252 and resist 240. In one example, the processing applies a second plating to a target thickness to create metal 234, with lip 236. Lip 236 represents the layer of metal 234 built up between resist 240 and cured region 252.

**Figure 2F** illustrates a cross-section view and a top view for circuit state 212. In circuit state 212, the processing can strip both layers of resist, leaving contact 260 with inner surface 262 and lip 264 on substrate 220. Lip 264 represents a vertical lip on the contact. The top view illustrates that surface 262 can be surrounded by lip 264.

**Figure 2G** illustrates a cross-section view of circuit state 214. Circuit state 214 illustrates that the processing can form multiple contacts 260, each with surface 262 and lip 264. The processing can cover the circuit with dielectric 270 (e.g., a bulk organic dielectric comprises such as ABF (Ajinomoto build-up film), or other dielectric layer or photo imageable dielectric material). The processing can create vias 272, such as with laser drilling or photolithographic processing to expose surface 262, or the landing to which a metal trace via or pillar can be electrically connected. Lip 264 extends vertically into dielectric 270. After forming vias 272, the processing can apply standard SAP processes for via bottom cleaning and e-less plating and e-lytic plating to fill with metal (such as copper).

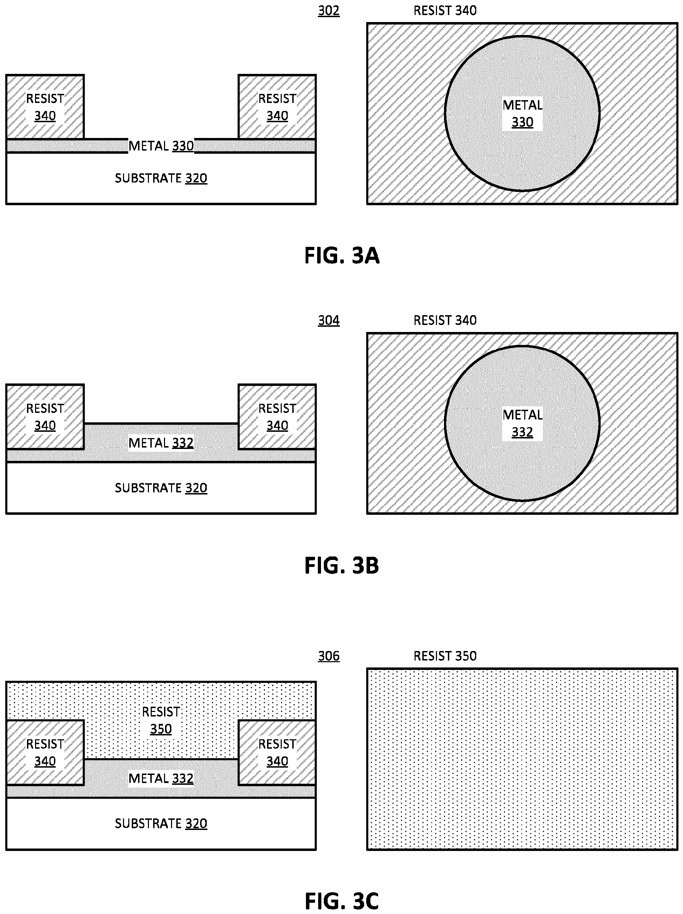

**Figures 3A-3G** represent stages in the creation of an integrated circuit with a metallic contact having a vertical lip with a tapered edge. **Figure 3A** illustrates circuit state 302, with metal layer 330 formed on substrate 320. The view on the left represents a cross-section view of the circuit state. The view on the right represents a top view of the circuit state. Circuit state 302 can represent a semi-additive process (SAP) process flow after an electroless (e-less) deposition layer of metal 330. In one example, substrate 320 represents an electronic circuit, such as what is described above. Metal 330 represents material for a metal contact on substrate 320, such as a copper pad.

In circuit state 302, the processing applies a layer of photoresist material represented as resist 340 in circuit state 302. There is an opening patterned into resist 340, which the top view represents as a circular opening in the resist to expose metal 330.

**Figure 3B** illustrates a cross-section view and a top view for circuit state 304. In circuit state 304, the metal layer is plated or formed in the patterned area of resist 340. Metal 332 represents the patterned metal layer plated to the desired thickness.

**Figure 3C** illustrates a cross-section view and a top view for circuit state 306. In circuit state 306, the processing can coat the metal layer and first resist layer, resist 340, with resist 350.

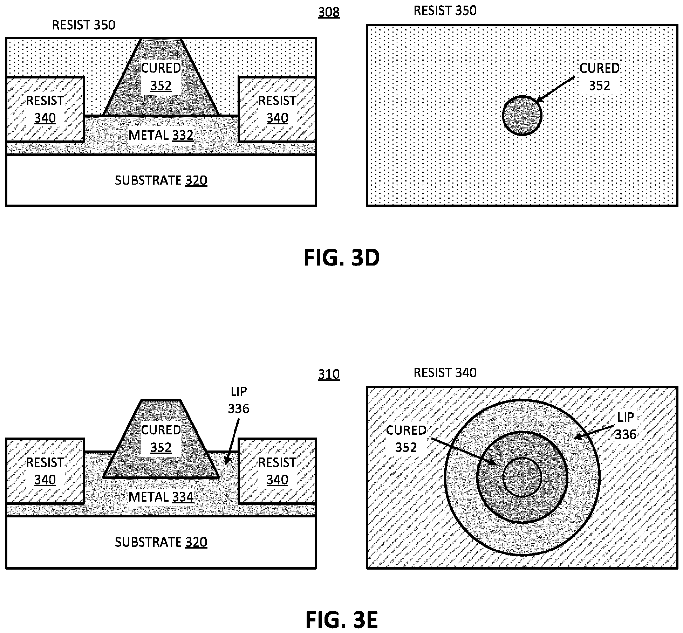

**Figure 3D** illustrates a cross-section view and a top view for circuit state 308. In circuit state 308, the processing exposes and develops resist 350 to create patterning represented by cured region 352, which represents the cured region of resist 350. Cured region 352 can pattern over metal 332 but not cover the entire metal region exposed by resist 340, which is the reason for the second resist layer.

In one example, the processing patterns resist 350 with light directed at an angle through prisms or other redirection mechanism. With prism-assisted lithography, the processing expose resist 350 at acute angles to create an acute angle of exposed resist 350. Thus, instead of resist 350 having an area cured at roughly 90 degrees (or slightly more than 90 degrees when practical factors are considered), cured region 352 leaves an angle that is less than 90 degrees.

**Figure 3E** illustrates a cross-section view and a top view for circuit state 310. In circuit state 310, the processing can remove the unpatterned or undeveloped region of resist 350 to expose a portion of the metal layer between cured region 352 and resist 340. In one example, the processing applies a second plating to a target thickness to create metal 334, with lip 336. Lip 336 represents the layer of metal 334 built up between resist 340 and cured region 352. Since lip 336 is formed around cured region 352, it can be observed that lip 336 will have an undercut region.

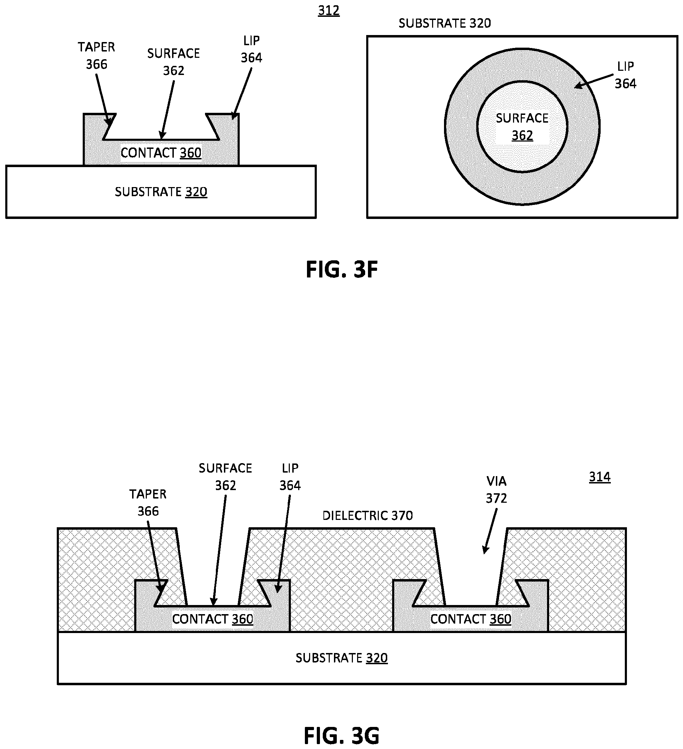

**Figure 3F** illustrates a cross-section view and a top view for circuit state 312. In circuit state 312, the processing can strip both layers of resist, leaving contact 360 with inner surface 362 and lip 364 on substrate 320. Lip 364 represents a vertical lip on the contact. The cross-section view illustrates that lip 364 includes taper 366, which is at an acute angle with respect to surface 362. The lip is wider at the top than at the place of connection with surface 362. The top view illustrates that surface 362 can be surrounded by lip 364.

**Figure 3G** illustrates a cross-section view of circuit 314. Circuit 314 illustrates that the processing can form multiple contacts 360, each with surface 362 and lip 364. The processing can cover the circuit with dielectric 370 (e.g., a bulk organic dielectric comprises such as ABF or other dielectric layer or photo imageable dielectric material). The processing can create vias 372, such as with laser drilling or photolithographic processing to expose surface 362, or the landing to which a metal trace via or pillar can be electrically connected. Lip 364 extends vertically into dielectric 370. Taper 366 can increase the mechanical interlock or the mechanical coupling of contact 360 with dielectric 370. After forming vias 372, the processing can apply standard SAP processes for via bottom cleaning and e-less plating and e-lytic plating to fill with metal (such as copper).

With an area smaller where lip 364 contacts surface 362 and an area larger at the top of the lip, lip 364 can be said to become larger as the vertical lip extends farther away substrate 320. In one example, the processing can achieve taper 366 with an under-etch cutout between the top of lip 364 and the bottom of lip 364 (where it connects to surface 362). In one example, the processing achieves taper 366 by photoresist exposure at an angle, instead of directly at the top of the resist layer.

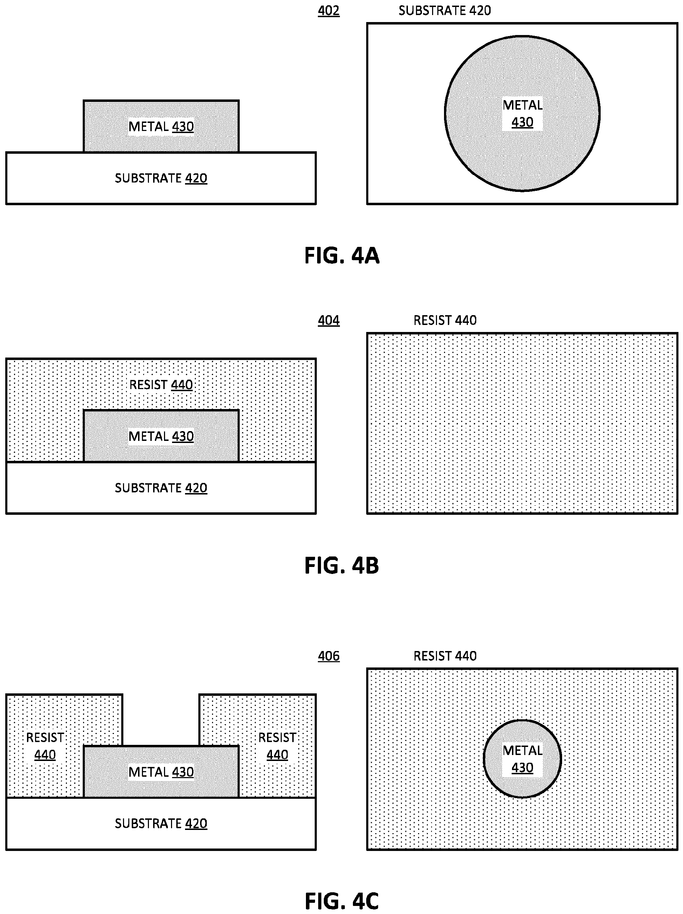

**Figures 4A-4F** represent stages in the creation of an integrated circuit with a metallic contact having a vertical lip with a scalloped edge. **Figure 4A** illustrates circuit state 402, with metal layer 430 formed on substrate 420. The view on the left represents a cross-section view of the circuit state. The view on the right represents a top view of the circuit state. Circuit state 402 can represent a semi-additive process (SAP) process flow after an electroless (e-less) deposition layer of metal 430.

In one example, substrate 420 represents an electronic circuit. In one example, substrate 420 represents a layer of electrical isolation, such as a nitride or oxide layer or ABF dielectric material, on which a contact will be formed to connect with traces or circuits under the contact through a pillar or via. Metal 430 represents material for a metal contact on substrate 420, such as a copper pad.

In circuit state 402, the processing can create metal 430 from patterning with photoresist application, metal plating, and photoresist removal. The top view represents metal 430 as a circular pad of metal.

**Figure 4B** illustrates a cross-section view and a top view for circuit state 404. In circuit state 404, the processing can coat the metal layer with resist 440.

**Figure 4C** illustrates a cross-section view and a top view for circuit state 406. In circuit state 406, the processing exposes and develops resist 440 to create patterned openings in resist 440 to expose metal 430. In one example, the processing patterns resist 440 to make an opening over part of metal 430 but not all of metal 430.

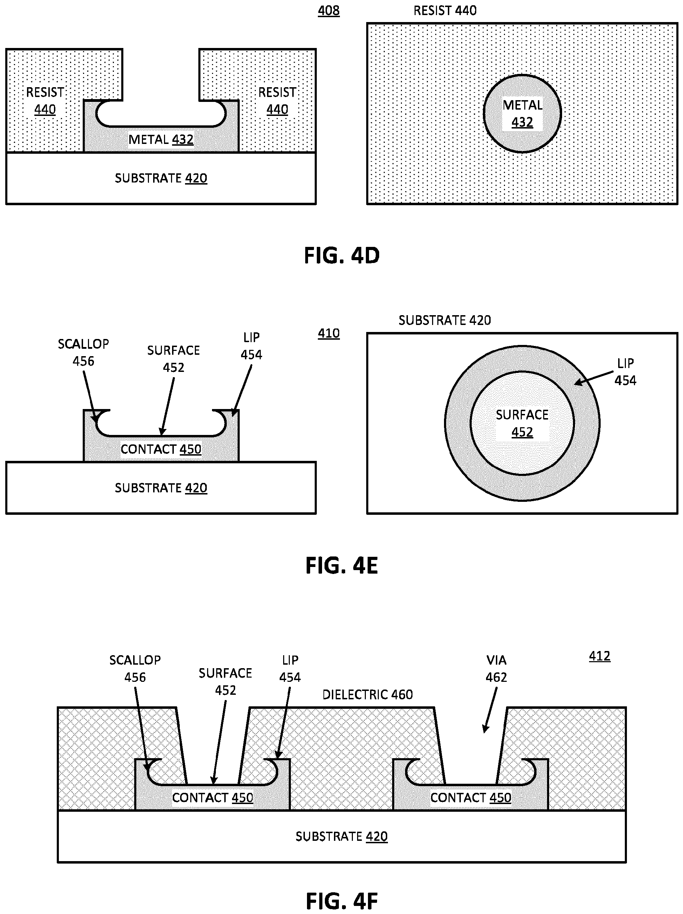

**Figure 4D** illustrates a cross-section view and a top view for circuit state 408. In circuit state 408, the processing can apply subtractive etching to remove a portion of the metal to create metal 432. In one example, the etching removes material under resist 440. Due to the resist over metal 432, the etching can be controlled to result in a scalloped edge in metal 432.

**Figure 4E** illustrates a cross-section view and a top view for circuit state 410. In circuit state 410, the processing can strip the resist, leaving contact 450 with inner surface 452 and lip 454 on substrate 420. Lip 454 represents a vertical lip on the contact. The cross-section view illustrates that lip 454 includes scallop 456. The lip is wider at the top and bottom or place of connection with surface 452, and the middle of lip 454 is cut in or carved out, giving it a narrower cross-section than the top and bottom of the lip. The top view illustrates that surface 452 can be surrounded by lip 454.

**Figure 4F** illustrates a cross-section view of circuit 412. Circuit 412 illustrates that the processing can form multiple contacts 450, each with surface 452 and lip 454 with scallop 456 representing a scalloped edge of the vertical lip. The processing can cover the circuit with dielectric 460 (e.g., a bulk organic dielectric comprises such as ABF or other dielectric layer or photo imageable dielectric material). The processing can create vias 462, such as with laser drilling or photolithographic processing to expose surface 452, or the landing to which a metal trace via or pillar can be electrically connected. Lip 454 extends vertically into dielectric 460. Scallop 456 can increase the mechanical interlock or the mechanical coupling of contact 450 with dielectric 460. After forming vias 462, the processing can apply standard SAP processes for via bottom cleaning and e-less plating and e-lytic plating to fill with metal (such as copper).

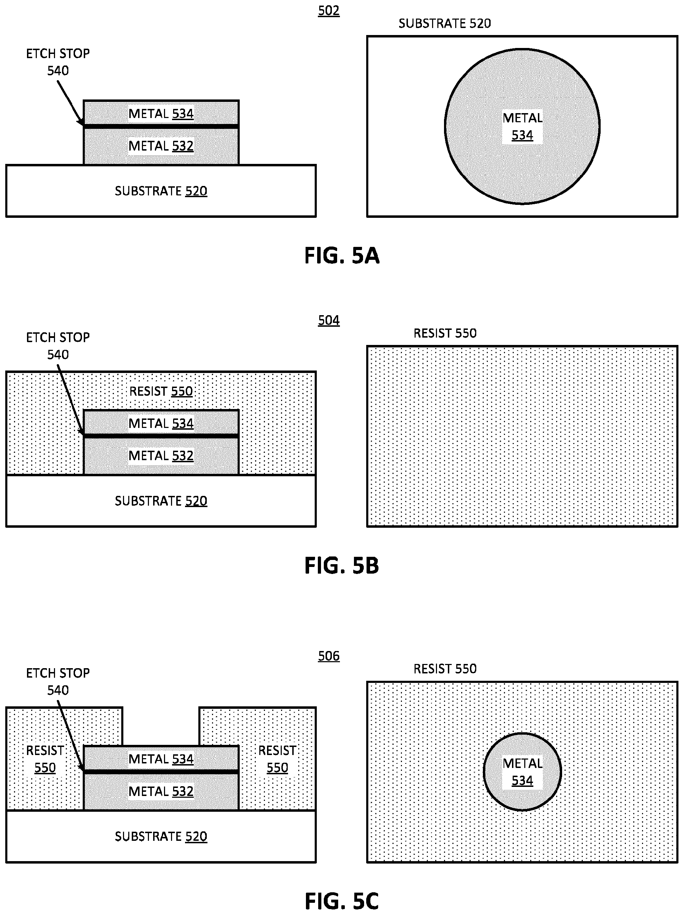

**Figures 5A-5G** represent stages in the creation of an integrated circuit with a metallic contact having a vertical lip with a ribbed edge. **Figure 5A** illustrates circuit state 502, with metal layer 532 formed on substrate 520, with etch stop layer 540 on top of metal layer 532, and metal layer 534 on top of etch stop 540. The view on the left represents a cross-section view of the circuit state. The view on the right represents a top view of the circuit state. Circuit state 502 can represent a circuit state after plating, photolithography, and removal of resist layers.

In one example, substrate 520 represents an electronic circuit. In one example, substrate 520 represents a layer of electrical isolation, such as a nitride or oxide layer or ABF dielectric material, on which a contact will be formed to connect with traces or circuits under the contact through a pillar or via. Metal 532 and metal 534 represent material for a metal contact on substrate 520, such as a copper pad.

In circuit state 502, the processing can create metal 532 and metal 534 from patterning with photoresist application, metal plating, and photoresist removal. The top view represents metal 534 as a circular pad of metal. Etch stop 540 can provide a different material between the layers of metal in preparation for subsequent circuit processing operations.

**Figure 5B** illustrates a cross-section view and a top view for circuit state 504. In circuit state 504, the processing can coat the metal layers with resist 550.

**Figure 5C** illustrates a cross-section view and a top view for circuit state 506. In circuit state 506, the processing exposes and develops resist 550 to create patterned openings in resist 550 to expose metal 534. In one example, the processing patterns resist 550 to make an opening over part of metal 534 but not all of metal 534.

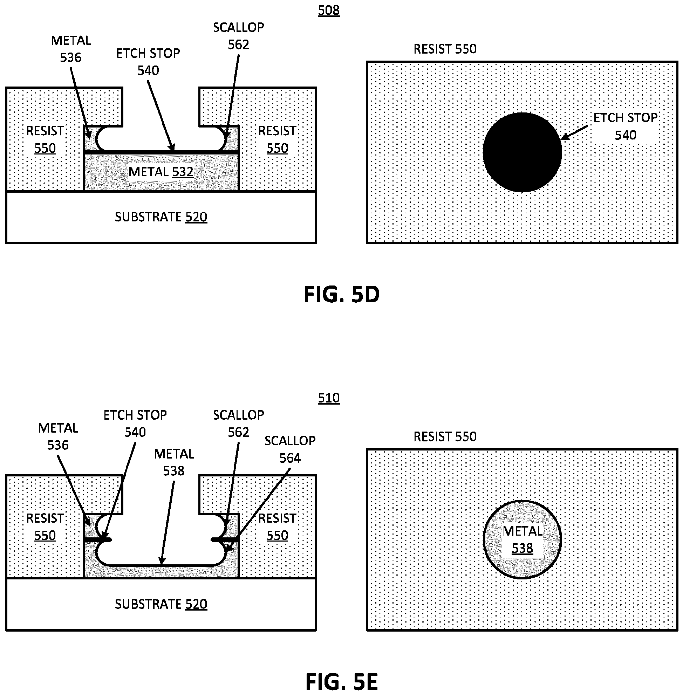

**Figure 5D** illustrates a cross-section view and a top view for circuit state 508. In circuit state 508, the processing can apply subtractive etching to remove a portion of the metal to create metal 536 out of metal 534. In one example, the etching removes material under resist 550. Due to the resist over metal 536, the etching can be controlled to result in a scalloped edge in metal 536, represented by scallop 562. It can be seen that the etching can be controlled to remove metal 536 all the way through the center to expose etch stop 540. Etch stop 540 allows the etching to form the desired shape in metal 536 without etching metal 532.

**Figure 5E** illustrates a cross-section view and a top view for circuit state 510. In circuit state 510, the processing can apply a different etching chemistry that removes etch stop 540 without removing metal 536. In one example, at least a portion of etch stop 540 will ring the outer edge of the contact, between metal portions of the lip. The processing can apply subtractive etching to remove a portion of metal 532 to create metal 538. In one example, the etching removes material under etch stop 540 to create a second scalloped edge, represented by scallop 564. It can be seen that the etching can be controlled to remove some of metal 538 while leaving a layer of metal over substrate 520.

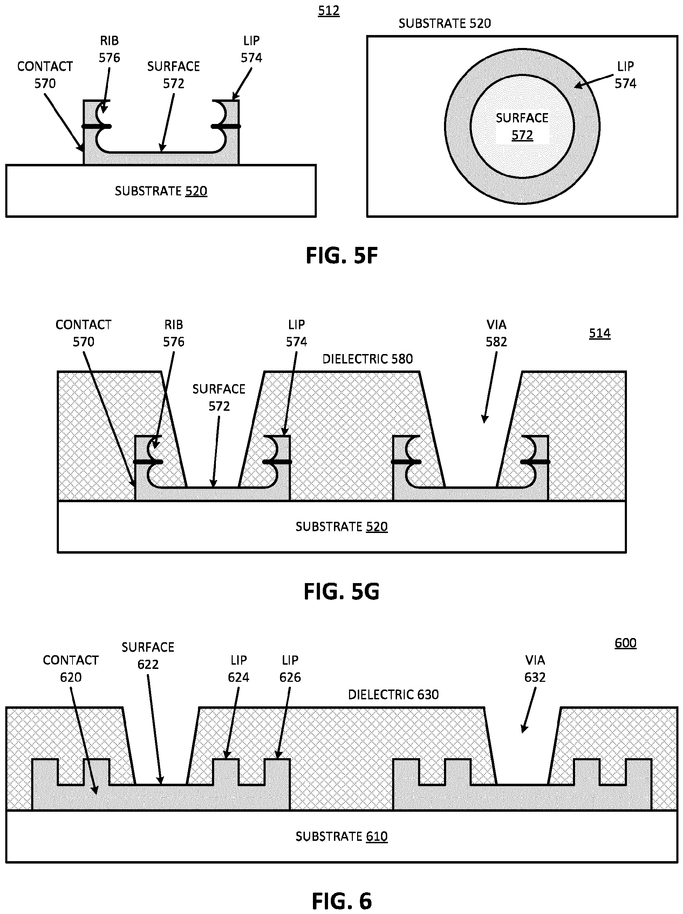

**Figure 5F** illustrates a cross-section view and a top view for circuit state 512. In circuit state 512, the processing can strip the resist, leaving contact 570 with inner surface 572 and lip 574 on substrate 520. Lip 574 represents a vertical lip on the contact. The cross-section view illustrates that lip 574 includes multiple scallops to form rib 576, or a ribbed edge. The lip is illustrated having two portions where the middle of the portion has a narrower cross-section than the top and bottom of the portion of metal. Rib 576 can be considered multiple layers of scalloped edges. Only two scalloped portions are illustrated in circuit state 512, but it will be understood that the processing can create more vertical portions in lip 574. The top view illustrates that surface 572 can be surrounded by lip 574.

**Figure 5G** illustrates a cross-section view of circuit 514. Circuit 514 illustrates that the processing can form multiple contacts 570, each with surface 572 and lip 574 with rib 576 representing a multi-scalloped edge of the vertical lip, or a ribbed edge with multiple etched cutouts. The processing can cover the circuit with dielectric 580 (e.g., a bulk organic dielectric comprises such as ABF or other dielectric layer or photo imageable dielectric material). The processing can create vias 582, such as with laser drilling or photolithographic processing to expose surface 572, or the landing to which a metal trace via or pillar can be electrically connected. Lip 574 extends vertically into dielectric 580. Scallops in rib 576 can increase the mechanical interlock or the mechanical coupling of contact 570 with dielectric 580. After forming vias 582, the processing can apply standard SAP processes for via bottom cleaning and e-less plating and e-lytic plating to fill with metal (such as copper).

**Figure 6** represents an example of an integrated circuit with a metallic contact having multiple vertical lips. Circuit 600 illustrates that the processing can form multiple contacts, each with multiple vertical stress arresting lips. The specific processing to create circuit 600 is not covered in detail. The processing can be in accordance with any processing described above, where circuit 600 can be a circuit in accordance with an example of circuit 214, an example of circuit 314, an example of circuit 412, or an example of circuit 514.

Circuit 600 illustrates multiple contacts 620 disposed on substrate 610. Each contact 620 includes surface 622 exposed at via 632 through dielectric 630 as a landing for a metal trace connection. Each contact 620 includes lip 624 as an inner lip, and lip 626 as an outer lip. While two lips are shown on contact 620, more than two lips can be formed. The lips are not necessarily to scale for the contact, and especially as multiple lips are formed on a contact, the lips can be smaller in scale and closer together.

Where the processing above represents forming a single lip, the patterning and processing can instead create concentric lips around the contact metal. Circuit 600 specifically illustrates two lips, lip 624 and lip 626, as straight structures, structures with tapered edges, scalloped edges, or ribbed edges could also be created. In theory, different edges could be formed. However, it will be understood that forming a contact with two different types of lip structures could require sequential processing sequences, which will increase cost and timelines for manufacturing. Alternatively, straight edges and tapered edges could be mixed by applying prism-assisted lithographic patterning and straight lithographic patterning to the same photoresist layers, potentially allowing two different lip structure types on the same contact.

It will be understood that the contact structure of circuit 600 is different from a roughening process, which creates peaks and valleys to roughen a metal structure. Unlike traditional roughening, the multi-lip patterning in circuit 600 is controlled and patterned, with repeated structural elements, as opposed to random structures that result from roughening.

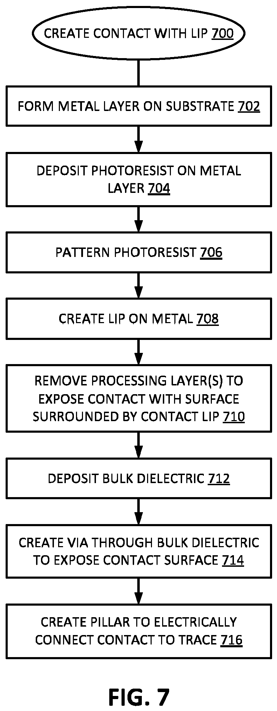

**Figure 7** is a flow diagram of an example of a process for creating an integrated circuit with a vertical lip on a metallic contact. Process 700 represents a process for creating vertical lip structures on a contact of an integrated circuit. Process 700 can represent operations of integrated circuit processing in accordance with an example of circuit 214, an example of circuit 314, an example of circuit 412, an example of circuit 514, or an example of circuit 600.

In one example, the forms a smooth metal layer on a substrate, at 702. The use of smooth metal provides low insertion loss. The patterning of vertical lip structures can increase the insertion loss relative to a completely smooth contact pad, but is much less than a roughened surface, with significantly improved mechanical stress properties relative to a roughened surface.

In one example, the processing deposit one or more layers of photoresist on the metal layer, at 704. The processing can include create different patterning in the different layers of photoresist, at 706. For multiple layers of photoresist, different patterning can enable the creation of different vertical lip structures. The processing can create the metal lip on the metal layer, at 708. The lip is a vertical structure extending away from the contact or away from the substrate on which the contact is formed.

In one example, the creation of the lip includes forming a straight vertical structure. In one example, the creation of the lip includes forming a scalloped structure. In one example, the creation of the lip includes photolithography with acute angles. In one example, the creation of the lip includes etching. In one example, the creation of the lip includes creating a tapered edge. In one example, the creation of the lip includes creating a ribbed structure.

The processing can remove processing layer(s), such as layers of photoresist or other sacrificial layers, to expose a surface of the contact surrounded by the contact lip structure, at 710. The processing can deposit a bulk dielectric over the circuitry, including the contact with the lip structure, at 712. The processing can create a via through the bulk dielectric to expose the contact surface surrounded by the vertical lip structure, at 714. The processing can create a conductive pillar to electrically connect the contact to a trace on the integrated circuit, at 716.

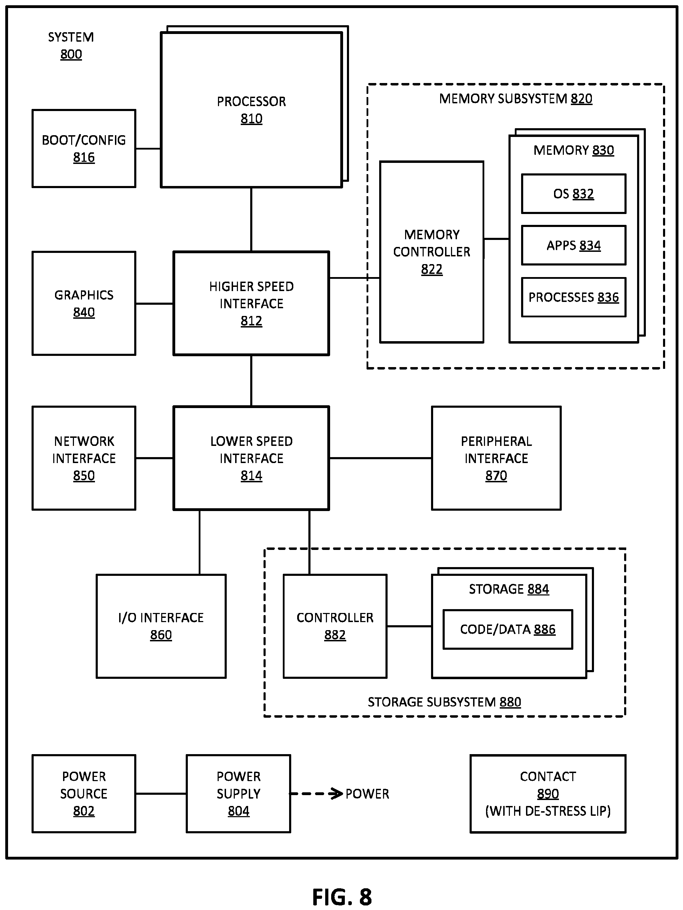

**Figure 8** is a block diagram of an example of a computing system in which an integrated circuit with a vertical lip on a metallic contact can be implemented. System 800 represents a computing device in accordance with any example herein, and can be a laptop computer, a desktop computer, a tablet computer, a server, a gaming or entertainment control system, embedded computing device, or other electronic device.

System 800 represents a computer system that includes one or more electronic chips or integrated circuit devices that include contact 890 with a de-stress lip or a lip structure to arrest stress. Contact 890 can include a vertical lip structure in accordance with any example herein.

System 800 includes processor 810 can include any type of microprocessor, central processing unit (CPU), graphics processing unit (GPU), processing core, or other processing hardware, or a combination, to provide processing or execution of instructions for system 800. Processor 810 can be a host processor device. Processor 810 controls the overall operation of system 800, and can be or include, one or more programmable general-purpose or special-purpose microprocessors, digital signal processors (DSPs), programmable controllers, application specific integrated circuits (ASICs), programmable logic devices (PLDs), or a combination of such devices.

System 800 includes boot/config 816, which represents storage to store boot code (e.g., basic input/output system (BIOS)), configuration settings, security hardware (e.g., trusted platform module (TPM)), or other system level hardware that operates outside of a host OS. Boot/config 816 can include a nonvolatile storage device, such as read-only memory (ROM), flash memory, or other memory devices.

In one example, system 800 includes interface 812 coupled to processor 810, which can represent a higher speed interface or a high throughput interface for system components that need higher bandwidth connections, such as memory subsystem 820 or graphics interface components 840. Interface 812 represents an interface circuit, which can be a standalone component or integrated onto a processor die. Interface 812 can be integrated as a circuit onto the processor die or integrated as a component on a system on a chip. Where present, graphics interface 840 interfaces to graphics components for providing a visual display to a user of system 800. Graphics interface 840 can be a standalone component or integrated onto the processor die or system on a chip. In one example, graphics interface 840 can drive a high definition (HD) display or ultra high definition (UHD) display that provides an output to a user. In one example, the display can include a touchscreen display. In one example, graphics interface 840 generates a display based on data stored in memory 830 or based on operations executed by processor 810 or both.

Memory subsystem 820 represents the main memory of system 800, and provides storage for code to be executed by processor 810, or data values to be used in executing a routine. Memory subsystem 820 can include one or more varieties of random-access memory (RAM) such as DRAM, 3DXP (three-dimensional crosspoint), or other memory devices, or a combination of such devices. Memory 830 stores and hosts, among other things, operating system (OS) 832 to provide a software platform for execution of instructions in system 800. Additionally, applications 834 can execute on the software platform of OS 832 from memory 830. Applications 834 represent programs that have their own operational logic to perform execution of one or more functions. Processes 836 represent agents or routines that provide auxiliary functions to OS 832 or one or more applications 834 or a combination. OS 832, applications 834, and processes 836 provide software logic to provide functions for system 800. In one example, memory subsystem 820 includes memory controller 822, which is a memory controller to generate and issue commands to memory 830. It will be understood that memory controller 822 could be a physical part of processor 810 or a physical part of interface 812. For example, memory controller 822 can be an integrated memory controller, integrated onto a circuit with processor 810, such as integrated onto the processor die or a system on a chip.

While not specifically illustrated, it will be understood that system 800 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 800 includes interface 814, which can be coupled to interface 812. Interface 814 can be a lower speed interface than interface 812. In one example, interface 814 represents an interface circuit, which can include standalone components and integrated circuitry. In one example, multiple user interface components or peripheral components, or both, couple to interface 814. Network interface 850 provides system 800 the ability to communicate with remote devices (e.g., servers or other computing devices) over one or more networks. Network interface 850 can include an Ethernet adapter, wireless interconnection components, cellular network interconnection components, USB (universal serial bus), or other wired or wireless standards-based or proprietary interfaces. Network interface 850 can exchange data with a remote device, which can include sending data stored in memory or receiving data to be stored in memory.

In one example, system 800 includes one or more input/output (I/O) interface(s) 860. I/O interface 860 can include one or more interface components through which a user interacts with system 800 (e.g., audio, alphanumeric, tactile/touch, or other interfacing). Peripheral interface 870 can include any hardware interface not specifically mentioned above. Peripherals refer generally to devices that connect dependently to system 800. A dependent connection is one where system 800 provides the software platform or hardware platform or both on which operation executes, and with which a user interacts.

In one example, system 800 includes storage subsystem 880 to store data in a nonvolatile manner. In one example, in certain system implementations, at least certain components of storage 880 can overlap with components of memory subsystem 820. Storage subsystem 880 includes storage device(s) 884, which can be or include any conventional medium for storing large amounts of data in a nonvolatile manner, such as one or more magnetic, solid state, NAND, 3DXP, or optical based disks, or a combination. Storage 884 holds code or instructions and data 886 in a persistent state (i.e., the value is retained despite interruption of power to system 800). Storage 884 can be generically considered to be a "memory," although memory 830 is typically the executing or operating memory to provide instructions to processor 810. Whereas storage 884 is nonvolatile, memory 830 can include volatile memory (i.e., the value or state of the data is indeterminate if power is interrupted to system 800). In one example, storage subsystem 880 includes controller 882 to interface with storage 884. In one example controller 882 is a physical part of interface 814 or processor 810, or can include circuits or logic in both processor 810 and interface 814.

Power source 802 provides power to the components of system 800. More specifically, power source 802 typically interfaces to one or multiple power supplies 804 in system 800 to provide power to the components of system 800. In one example, power supply 804 includes an AC to DC (alternating current to direct current) adapter to plug into a wall outlet. Such AC power can be renewable energy (e.g., solar power) power source 802. In one example, power source 802 includes a DC power source, such as an external AC to DC converter. In one example, power source 802 or power supply 804 includes wireless charging hardware to charge via proximity to a charging field. In one example, power source 802 can include an internal battery or fuel cell source.

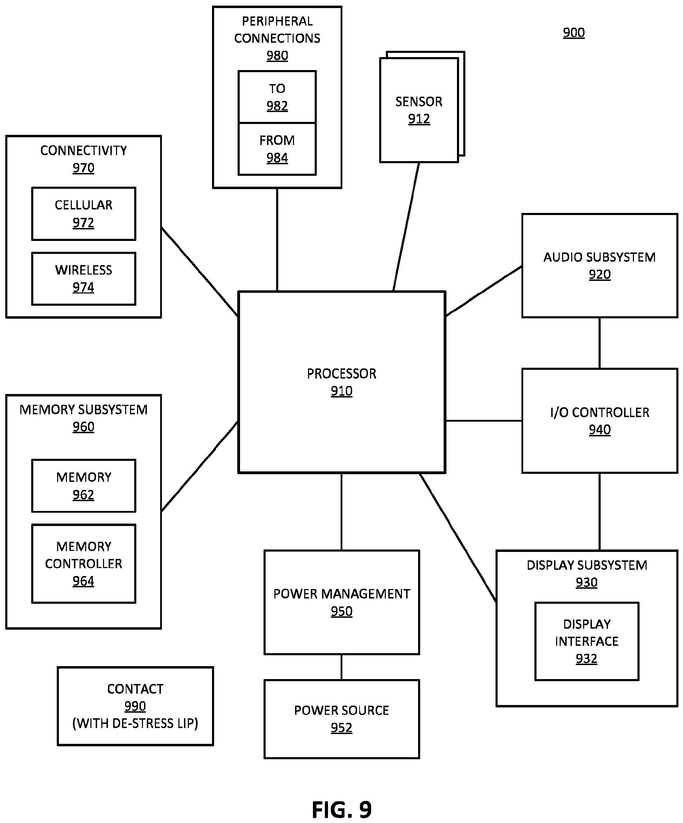

**Figure 9** is a block diagram of an example of a mobile device in which an integrated circuit with a vertical lip on a metallic contact can be implemented. System 900 represents a mobile computing device, such as a computing tablet, a mobile phone or smartphone, wearable computing device, or other mobile device, or an embedded computing device. It will be understood that certain of the components are shown generally, and not all components of such a device are shown in system 900.

System 900 represents a computer system that includes one or more electronic chips or integrated circuit devices that include contact 990 with a de-stress lip or a lip structure to arrest stress. Contact 990 can include a vertical lip structure in accordance with any example herein.

System 900 includes processor 910, which performs the primary processing operations of system 900. Processor 910 can be a host processor device. Processor 910 can include one or more physical devices, such as microprocessors, application processors, microcontrollers, programmable logic devices, or other processing means. The processing operations performed by processor 910 include the execution of an operating platform or operating system on which applications and device functions are executed. The processing operations include operations related to I/O (input/output) with a human user or with other devices, operations related to power management, operations related to connecting system 900 to another device, or a combination. The processing operations can also include operations related to audio I/O, display I/O, or other interfacing, or a combination. Processor 910 can execute data stored in memory. Processor 910 can write or edit data stored in memory.

In one example, system 900 includes one or more sensors 912. Sensors 912 represent embedded sensors or interfaces to external sensors, or a combination. Sensors 912 enable system 900 to monitor or detect one or more conditions of an environment or a device in which system 900 is implemented. Sensors 912 can include environmental sensors (such as temperature sensors, motion detectors, light detectors, cameras, chemical sensors (e.g., carbon monoxide, carbon dioxide, or other chemical sensors)), pressure sensors, accelerometers, gyroscopes, medical or physiology sensors (e.g., biosensors, heart rate monitors, or other sensors to detect physiological attributes), or other sensors, or a combination. Sensors 912 can also include sensors for biometric systems such as fingerprint recognition systems, face detection or recognition systems, or other systems that detect or recognize user features. Sensors 912 should be understood broadly, and not limiting on the many different types of sensors that could be implemented with system 900. In one example, one or more sensors 912 couples to processor 910 via a frontend circuit integrated with processor 910. In one example, one or more sensors 912 couples to processor 910 via another component of system 900.

In one example, system 900 includes audio subsystem 920, which represents hardware (e.g., audio hardware and audio circuits) and software (e.g., drivers, codecs) components associated with providing audio functions to the computing device. Audio functions can include speaker or headphone output, as well as microphone input. Devices for such functions can be integrated into system 900, or connected to system 900. In one example, a user interacts with system 900 by providing audio commands that are received and processed by processor 910.

Display subsystem 930 represents hardware (e.g., display devices) and software components (e.g., drivers) that provide a visual display for presentation to a user. In one example, the display includes tactile components or touchscreen elements for a user to interact with the computing device. Display subsystem 930 includes display interface 932, which includes the particular screen or hardware device used to provide a display to a user. In one example, display interface 932 includes logic separate from processor 910 (such as a graphics processor) to perform at least some processing related to the display. In one example, display subsystem 930 includes a touchscreen device that provides both output and input to a user. In one example, display subsystem 930 includes a high definition (HD) or ultra-high definition (UHD) display that provides an output to a user. In one example, display subsystem includes or drives a touchscreen display. In one example, display subsystem 930 generates display information based on data stored in memory or based on operations executed by processor 910 or both.

I/O controller 940 represents hardware devices and software components related to interaction with a user. I/O controller 940 can operate to manage hardware that is part of audio subsystem 920, or display subsystem 930, or both. Additionally, I/O controller 940 illustrates a connection point for additional devices that connect to system 900 through which a user might interact with the system. For example, devices that can be attached to system 900 might include microphone devices, speaker or stereo systems, video systems or other display device, keyboard or keypad devices, buttons/switches, or other I/O devices for use with specific applications such as card readers or other devices.

As mentioned above, I/O controller 940 can interact with audio subsystem 920 or display subsystem 930 or both. For example, input through a microphone or other audio device can provide input or commands for one or more applications or functions of system 900. Additionally, audio output can be provided instead of or in addition to display output. In another example, if display subsystem includes a touchscreen, the display device also acts as an input device, which can be at least partially managed by I/O controller 940. There can also be additional buttons or switches on system 900 to provide I/O functions managed by I/O controller 940.

In one example, I/O controller 940 manages devices such as accelerometers, cameras, light sensors or other environmental sensors, gyroscopes, global positioning system (GPS), or other hardware that can be included in system 900, or sensors 912. The input can be part of direct user interaction, as well as providing environmental input to the system to influence its operations (such as filtering for noise, adjusting displays for brightness detection, applying a flash for a camera, or other features).

In one example, system 900 includes power management 950 that manages battery power usage, charging of the battery, and features related to power saving operation. Power management 950 manages power from power source 952, which provides power to the components of system 900. In one example, power source 952 includes an AC to DC (alternating current to direct current) adapter to plug into a wall outlet. Such AC power can be renewable energy (e.g., solar power, motion based power). In one example, power source 952 includes only DC power, which can be provided by a DC power source, such as an external AC to DC converter. In one example, power source 952 includes wireless charging hardware to charge via proximity to a charging field. In one example, power source 952 can include an internal battery or fuel cell source.

Memory subsystem 960 includes memory device(s) 962 for storing information in system 900. Memory subsystem 960 can include nonvolatile (state does not change if power to the memory device is interrupted) or volatile (state is indeterminate if power to the memory device is interrupted) memory devices, or a combination. Memory 960 can store application data, user data, music, photos, documents, or other data, as well as system data (whether long-term or temporary) related to the execution of the applications and functions of system 900. In one example, memory subsystem 960 includes memory controller 964 (which could also be considered part of the control of system 900, and could potentially be considered part of processor 910). Memory controller 964 includes a scheduler to generate and issue commands to control access to memory device 962.

Connectivity 970 includes hardware devices (e.g., wireless or wired connectors and communication hardware, or a combination of wired and wireless hardware) and software components (e.g., drivers, protocol stacks) to enable system 900 to communicate with external devices. The external device could be separate devices, such as other computing devices, wireless access points or base stations, as well as peripherals such as headsets, printers, or other devices. In one example, system 900 exchanges data with an external device for storage in memory or for display on a display device. The exchanged data can include data to be stored in memory, or data already stored in memory, to read, write, or edit data.

Connectivity 970 can include multiple different types of connectivity. To generalize, system 900 is illustrated with cellular connectivity 972 and wireless connectivity 974. Cellular connectivity 972 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution - also referred to as "4G"), 5G, or other cellular service standards. Wireless connectivity 974 refers to wireless connectivity that is not cellular, and can include personal area networks (such as Bluetooth), local area networks (such as WiFi), or wide area networks (such as WiMax), or other wireless communication, or a combination. Wireless communication refers to transfer of data through the use of modulated electromagnetic radiation through a non-solid medium. Wired communication occurs through a solid communication medium.

Peripheral connections 980 include hardware interfaces and connectors, as well as software components (e.g., drivers, protocol stacks) to make peripheral connections. It will be understood that system 900 could both be a peripheral device ("to" 982) to other computing devices, as well as have peripheral devices ("from" 984) connected to it. System 900 commonly has a "docking" connector to connect to other computing devices for purposes such as managing (e.g., downloading, uploading, changing, synchronizing) content on system 900. Additionally, a docking connector can allow system 900 to connect to certain peripherals that allow system 900 to control content output, for example, to audiovisual or other systems.

In addition to a proprietary docking connector or other proprietary connection hardware, system 900 can make peripheral connections 980 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), or other type.

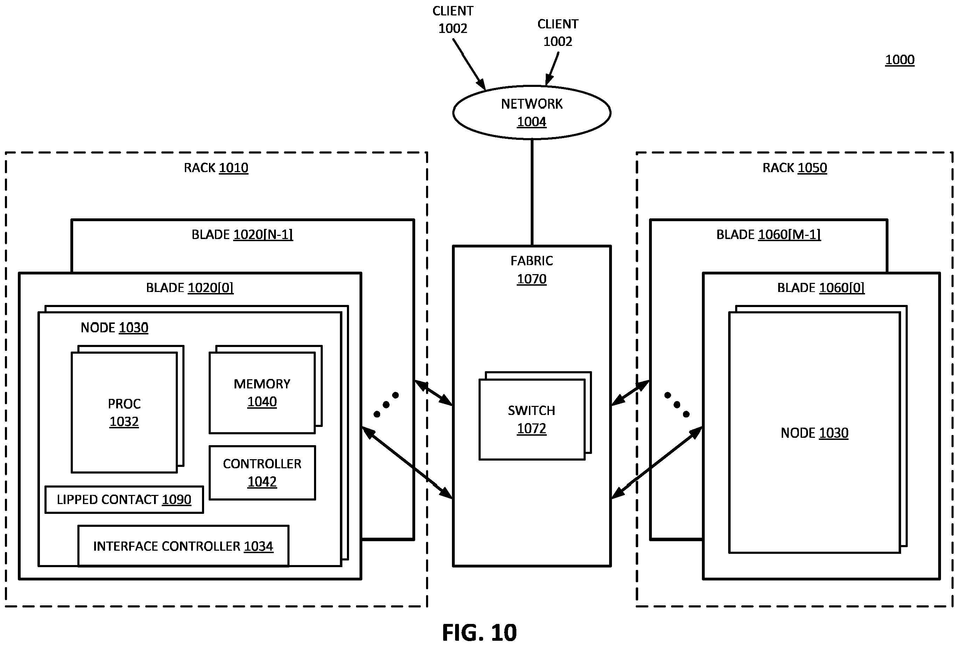

**Figure 10** is a block diagram of an example of a multi-node network in which an integrated circuit with a vertical lip on a metallic contact can be implemented. System 1000 represents a network of nodes that can apply adaptive ECC. In one example, system 1000 represents a data center. In one example, system 1000 represents a server farm. In one example, system 1000 represents a data cloud or a processing cloud.

System 1000 includes node 1030, which represents a computer system that includes one or more electronic chips or integrated circuit devices that include contact 1090 with a de-stress lip or a lip structure to arrest stress. Contact 1090 can include a vertical lip structure in accordance with any example herein.

One or more clients 1002 make requests over network 1004 to system 1000. Network 1004 represents one or more local networks, or wide area networks, or a combination. Clients 1002 can be human or machine clients, which generate requests for the execution of operations by system 1000. System 1000 executes applications or data computation tasks requested by clients 1002.

In one example, system 1000 includes one or more racks, which represent structural and interconnect resources to house and interconnect multiple computation nodes. In one example, rack 1010 includes multiple nodes 1030. In one example, rack 1010 hosts multiple blade components 1020. Hosting refers to providing power, structural or mechanical support, and interconnection. Blades 1020 can refer to computing resources on printed circuit boards (PCBs), where a PCB houses the hardware components for one or more nodes 1030. In one example, blades 1020 do not include a chassis or housing or other "box" other than that provided by rack 1010. In one example, blades 1020 include housing with exposed connector to connect into rack 1010. In one example, system 1000 does not include rack 1010, and each blade 1020 includes a chassis or housing that can stack or otherwise reside in close proximity to other blades and allow interconnection of nodes 1030.

System 1000 includes fabric 1070, which represents one or more interconnectors for nodes 1030. In one example, fabric 1070 includes multiple switches 1072 or routers or other hardware to route signals among nodes 1030. Additionally, fabric 1070 can couple system 1000 to network 1004 for access by clients 1002. In addition to routing equipment, fabric 1070 can be considered to include the cables or ports or other hardware equipment to couple nodes 1030 together. In one example, fabric 1070 has one or more associated protocols to manage the routing of signals through system 1000. In one example, the protocol or protocols is at least partly dependent on the hardware equipment used in system 1000.

As illustrated, rack 1010 includes N blades 1020. In one example, in addition to rack 1010, system 1000 includes rack 1050. As illustrated, rack 1050 includes M blades 1060. M is not necessarily the same as N; thus, it will be understood that various different hardware equipment components could be used, and coupled together into system 1000 over fabric 1070. Blades 1060 can be the same or similar to blades 1020. Nodes 1030 can be any type of node and are not necessarily all the same type of node. System 1000 is not limited to being homogenous, nor is it limited to not being homogenous.

For simplicity, only the node in blade 1020[0] is illustrated in detail. However, other nodes in system 1000 can be the same or similar. At least some nodes 1030 are computation nodes, with processor (proc) 1032 and memory 1040. A computation node refers to a node with processing resources (e.g., one or more processors) that executes an operating system and can receive and process one or more tasks. In one example, at least some nodes 1030 are server nodes with a server as processing resources represented by processor 1032 and memory 1040. A storage server refers to a node with more storage resources than a computation node, and rather than having processors for the execution of tasks, a storage server includes processing resources to manage access to the storage nodes within the storage server.

In one example, node 1030 includes interface controller 1034, which represents logic to control access by node 1030 to fabric 1070. The logic can include hardware resources to interconnect to the physical interconnection hardware. The logic can include software or firmware logic to manage the interconnection. In one example, interface controller 1034 is or includes a host fabric interface, which can be a fabric interface in accordance with any example described herein.

Processor 1032 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory 1040 can be or include memory devices and controller 1042 controls access to memory 1040.

In general with respect to the descriptions herein, in one example an electronic assembly includes: a semiconductor circuit substrate; and a metallic contact integrated onto the semiconductor circuit substrate, the metallic contact having a contact surface to make electrical contact with a trace through a dielectric layer over the semiconductor circuit substrate and the metallic contact, the metallic contact including a vertical lip extending vertically into the dielectric layer above the contact surface.

In one example of the electronic assembly, the metallic contact comprises copper. In accordance with any preceding example of the electronic assembly, in one example, the vertical lip comprises a vertical structure having a tapered edge, with the vertical lip becoming larger as the vertical lip extends farther away from the semiconductor circuit substrate. In accordance with any preceding example of the electronic assembly, in one example, the vertical lip has an under-etch cutout between a top of the vertical lip and a bottom of the vertical lip. In accordance with any preceding example of the electronic assembly, in one example, the vertical lip has a cutout from a photoresist exposed at an acute angle. In accordance with any preceding example of the electronic assembly, in one example, the vertical lip has a scalloped edge. In accordance with any preceding example of the electronic assembly, in one example, the vertical lip has a ribbed edge having multiple etched cutouts. In accordance with any preceding example of the electronic assembly, in one example, the vertical lip comprises a first vertical lip and further comprising a second vertical lip extending vertically into the dielectric layer above the contact surface.

In general with respect to the descriptions herein, in one example a computer system includes: an integrated circuit processed onto a substrate; a metallic contact integrated on the substrate, the metallic contact having a contact surface to make electrical contact with a trace through a dielectric layer over the substrate and the metallic contact, the metallic contact including a vertical lip extending vertically into the dielectric layer above the contact surface; and a trace to connect a package pad to the metallic contact.

In one example of the computer system, the vertical lip comprises a vertical structure having a tapered edge, with the vertical lip becoming larger as the vertical lip extends farther away from the substrate. In accordance with any preceding example of the computer system, in one example, the vertical lip has an under-etch cutout between a top of the vertical lip and a bottom of the vertical lip or wherein the vertical lip has a cutout from a photoresist exposed at an acute angle. In accordance with any preceding example of the computer system, in one example, the vertical lip has a scalloped edge. In accordance with any preceding example of the computer system, in one example, the vertical lip has a ribbed edge having multiple etched cutouts. In accordance with any preceding example of the computer system, in one example, vertical lip comprises a first vertical lip and further comprising a second vertical lip extending vertically into the dielectric layer above the contact surface. In accordance with any preceding example of the computer system, in one example, the computer system includes one or more of: a multicore host processor coupled to the integrated circuit; a display communicatively coupled to a processor; a network interface communicatively coupled to a processor; or a battery to power the computer system.

In general with respect to the descriptions herein, in one example a method includes: forming a metallic contact on a semiconductor circuit substrate; depositing a dielectric layer over the metallic contact, the metallic contact having a contact surface to make electrical contact with a trace; depositing a vertical lip on the metallic contact extending vertically into the dielectric layer above the contact surface; and depositing a dielectric layer over the semiconductor circuit substrate and the metallic contact.

In one example of the method, in one example, the method includes: forming a vertical channel through the dielectric layer to make the electrical contact with the trace. In accordance with any preceding example of the method, in one example, depositing the vertical lip comprises creating a vertical structure having a tapered edge, with the vertical lip becoming larger as the vertical lip extends farther away from the semiconductor circuit substrate. In accordance with any preceding example of the method, in one example, depositing the vertical lip comprises creating a vertical structure having a scalloped edge. In accordance with any preceding example of the method, in one example, depositing the vertical lip comprises creating a vertical structure having multiple etched cutouts. In accordance with any preceding example of the method, in one example, the vertical lip comprises a first vertical lip and further comprising: depositing a second vertical lip extending vertically into the dielectric layer above the contact surface.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A computer system, comprising:
a semiconductor circuit substrate; and
a metallic contact integrated onto the semiconductor circuit substrate, the metallic contact having a contact surface to make electrical contact with a trace through a dielectric layer over the semiconductor circuit substrate and the metallic contact, the metallic contact including a vertical lip extending vertically into the dielectric layer above the contact surface.

2. The computer system of claim 1, wherein the metallic contact comprises copper.

3. The computer system of either claim 1 or 2, wherein the vertical lip comprises a vertical structure having a tapered edge, with the vertical lip becoming larger as the vertical lip extends farther away from the semiconductor circuit substrate.

4. The computer system of claim 3, wherein the vertical lip has an under-etch cutout between a top of the vertical lip and a bottom of the vertical lip.

5. The computer system of claim 3, wherein the vertical lip has a cutout from a photoresist exposed at an acute angle.

6. The computer system of any of claims 1 to 5, wherein the vertical lip has a scalloped edge or wherein the vertical lip has a ribbed edge having multiple etched cutouts.

7. The computer system of any of claims 1 to 6, wherein the vertical lip comprises a first vertical lip and further comprising a second vertical lip extending vertically into the dielectric layer above the contact surface.

8. The computer system of any of claims 1 to 7, comprising:
a trace to connect a package pad to the metallic contact.

9. The computer system of any of claims 1 to 8, further comprising one or more of:
a multicore host processor coupled to the integrated circuit;
a display communicatively coupled to a processor;
a network interface communicatively coupled to a processor; or
a battery to power the computer system.

10. A method comprising:
forming a metallic contact on a semiconductor circuit substrate;
depositing a dielectric layer over the metallic contact, the metallic contact having a contact surface to make electrical contact with a trace;
depositing a vertical lip on the metallic contact extending vertically into the dielectric layer above the contact surface; and
depositing a dielectric layer over the semiconductor circuit substrate and the metallic contact.

11. The method of claim 10, further comprising:
forming a vertical channel through the dielectric layer to make the electrical contact with the trace.

12. The method of either claims 10 or 11, wherein depositing the vertical lip comprises creating a vertical structure having a tapered edge, with the vertical lip becoming larger as the vertical lip extends farther away from the semiconductor circuit substrate.

13. The method of any of claims 10 to 12, wherein depositing the vertical lip comprises creating a vertical structure having a scalloped edge.

14. The method of any of claims 10 to 13, wherein depositing the vertical lip comprises creating a vertical structure having multiple etched cutouts.

15. The method of any of claims 10 to 14, wherein the vertical lip comprises a first vertical lip and further comprising:
depositing a second vertical lip extending vertically into the dielectric layer above the contact surface.
